# EUROPEAN PATENT SPECIFICATION

(11) **EP 4 607 496 B1**
(45) Date of publication and mention of the grant of the patent: **09.12.2026**
(21) Application number: 23907354.7
(22) Date of filing: 20.10.2023
(51) Int. Cl.: G09F 9/302, H01R 13/639

(54) **DISPLAY APPARATUS**
ANZEIGEGERÄT
APPAREIL D'AFFICHAGE

(30) Priority: 23.12.2022 KR 20220183593
(43) Date of publication of application: 27.08.2025
(73) Proprietor: Samsung Electronics Co., Ltd., Suwon-si, Gyeonggi-do 16677 (KR)
(72) Inventor: KIM, Dowan, Suwon-si Gyeonggi-do 16677 (KR); KIM, Kiwoong, Suwon-si Gyeonggi-do 16677 (KR); KIM, Yoonah, Suwon-si Gyeonggi-do 16677 (KR); PARK, Chiun, Suwon-si Gyeonggi-do 16677 (KR); JEON, Jinhyeong, Suwon-si Gyeonggi-do 16677 (KR); HWANG, Kwangsung, Suwon-si Gyeonggi-do 16677 (KR)
(74) Representative: Appleyard Lees IP LLP
(86) International application number: PCT/KR2023/016393
(87) International publication number: WO 2024/136068

(56) References cited:
- JP-A- 2016 512 901
- KR-A- 20160 076 765
- KR-A- 20160 076 765
- KR-B1- 102 270 484
- KR-B1- 102 272 059
- KR-U- 20110 005 598
- KR-U- 970 011 245

## Description

### [TECHNICAL FIELD]

The disclosure relates to a display apparatus, and more particularly, to a display apparatus having increased reliability and ease of use by attaching a cover or wire conduit to a power connector.

### [BACKGROUND ART]

A display device is a type of output device that converts acquired or stored electrical information into visual information and displays such information to a user.

To realize a large-sized screen, a display device may include a plurality of display modules and a cabinet supporting the plurality of display modules by continuously tiling them in the up, down, left, and right directions. The cabinets supporting the plurality of display modules may be provided as a plurality, and the plurality of cabinets may be arranged to be continuously tiled in the up, down, left, and right directions as are the plurality of display modules. The plurality of display modules supported by the plurality of cabinets may form a single large-sized screen.

In addition, the display device includes a circuit case coupled to the cabinet and may supply power to the plurality of display modules via a power supply arranged therein. One side of the circuit case may be provided with a power connector for receiving power from an external source.

The display device may be installed outdoors rather than indoors. In particular, when the power connector is exposed to the outside, the power connector may be damaged or failure due to weather conditions such as rain or snow, or animals appearing near the installation area. Therefore, it is important that, when the power connector is not in use, the power connector may be prevented from damage and failure by covering the power connector with a cover, and the cover may not be easily separated from the power connector.

On the other hand, even when a wire conduit supplying power from an external source is connected to the power connector outdoors, the wire conduit need not to be easily separated from the power connector in order to reliably supply power to the display module.

### [DISCLOSURE]

### [TECHNICAL PROBLEM]

An embodiment of the present disclosure provides a display apparatus in which damage and failure may be prevented by locking a cover or wire conduit coupled to a power connector so as not to detach therefrom.

An embodiment of the present disclosure provides a display apparatus in which, by locking a cover or wire conduit coupled to a power connector by a simple structure, the cover or wire conduit may be easily attached and detached as needed.

Technical tasks to be achieved in this document are not limited to the technical tasks mentioned above, and other technical tasks not mentioned will be clearly understood by those skilled in the art from the description below.

### [TECHNICAL SOLUTION]

According to an embodiment of the disclosure, a display apparatus may include a display module, a cabinet to which the display module is coupled, a circuit case coupled to the cabinet and receiving a printed circuit board, a power connector arranged on one wall of the circuit case to supply power to the printed circuit board, a cover detachably coupled to the power connector, and a locking member coupled to the one wall of the circuit case on which the power connector is arranged, and configured to lock the cover by preventing rotation of the cover when the cover is coupled to the power connector.

According to an embodiment of the disclosure, a display apparatus may include a display module, a cabinet to which the display module is coupled, a circuit case coupled to the cabinet and configured to receive a printed circuit board, a power connector arranged on one wall of the circuit case to supply power to the printed circuit board, a wire conduit connectable to the power connector to supply power to the display module from an outside, and a locking member coupled to the one wall of the circuit case on which the power connector is arranged, the locking member sliding toward the wire conduit to lock the wire conduit when the wire conduit is coupled to the power connector.

According to an embodiment of the disclosure, a display apparatus may include a display module configured to display image information facing forward, a cabinet coupled to a rear side of the display module, a circuit case coupled to the cabinet and configured to receive a printed circuit board, a power connector arranged on a side wall of the circuit case to supply power to the printed circuit board, a cover detachably coupled to the power connector, and a locking member coupled to the side wall of the circuit case and configured to contact the cover to lock the cover so as to prevent rotation of the cover when the cover is coupled to the power connector.

### [ADVANTAGEOUS EFFECTS]

According to various embodiments of the present disclosure, by locking the cover or wire conduit coupled to the power connector in two stages, the display apparatus may be provided in which damage and failure may be prevented by preventing the cover or wire conduit from being detached when not needed.

According to an aspect of the present disclosure, by locking the cover or wire conduit coupled to the power connector by a simple structure, the display apparatus may be provided in which the cover or wire conduit may be easily locked and detached as needed.

The effects to be obtained from the present disclosure are not limited to those mentioned above, and other effects not mentioned will be apparent to those of skilled in the art from the following description.

### [DESCRIPTION OF DRAWINGS]

FIG. 1 is a perspective view of a display apparatus according to an embodiment.
FIG. 2 is an exploded perspective view of the display apparatus according to an embodiment.
FIG. 3 is a partially enlarged view of the display apparatus of FIG. 2.
FIG. 4 is a rear exploded perspective view of the display apparatus according to an embodiment.
FIG. 5 is a rear exploded perspective view of a display module in the display apparatus according to an embodiment.
FIG. 6 is a front view of a cabinet in the display apparatus according to an embodiment.
FIG. 7 is a partially enlarged view of the display apparatus according to an embodiment.
FIGS. 8 and 9 are exploded perspective views of some configurations of the display apparatus shown in FIG. 7.
FIGS. 10 to 17 are views illustrating a process in which a locking member locks a cover in the display apparatus according to an embodiment.
FIG. 18 is a side cross-sectional view of the display apparatus according to an embodiment.
FIGS. 19 to 22 are views illustrating a process in which the locking member locks the cover in the display apparatus according to an embodiment.

### [MODES OF THE INVENTION]

Embodiments described in the disclosure and configurations shown in the drawings are merely examples of the embodiments of the disclosure and may be modified in various different ways at the time of filing of the present application to replace the embodiments and drawings of the disclosure.

In addition, the same reference numerals or signs shown in the drawings of the disclosure indicate elements or components performing substantially the same function.

Also, the terms used herein are used to describe the embodiments and are not intended to limit and/or restrict the disclosure. The singular forms "a," "an" and "the" are intended to include the plural forms as well, unless the context clearly indicates otherwise. In this disclosure, the terms "including", "having", and the like are used to specify features, figures, steps, operations, elements, components, or combinations thereof, but do not preclude the presence or addition of one or more of the features, figures, steps, operations, elements, components, or combinations thereof.

It will be understood that, although the terms first, second, primary, secondary, etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and/or" includes a plurality of combinations of relevant items or any one item among a plurality of relevant items.

Further, as used in the disclosure, the terms "front", "rear", "top", "bottom", "side", "left", "right", "upper", "lower", and the like are defined with reference to the drawings, and are not intended to limit the shape and position of each component.

Various embodiments of the present disclosure will be described in detail below with reference to the accompanying drawings.

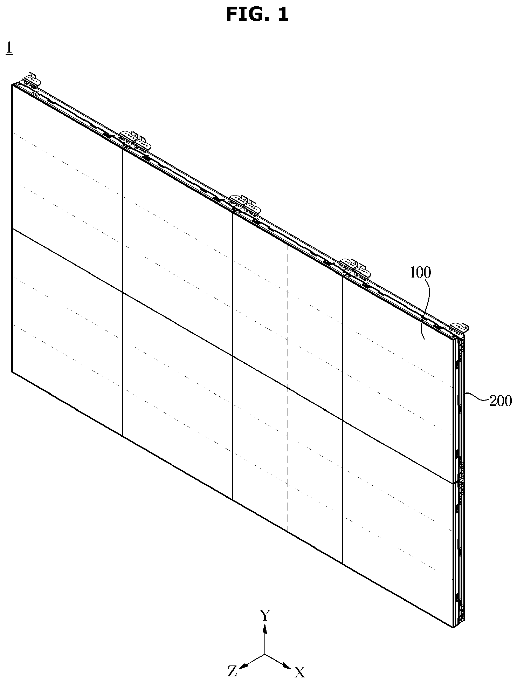

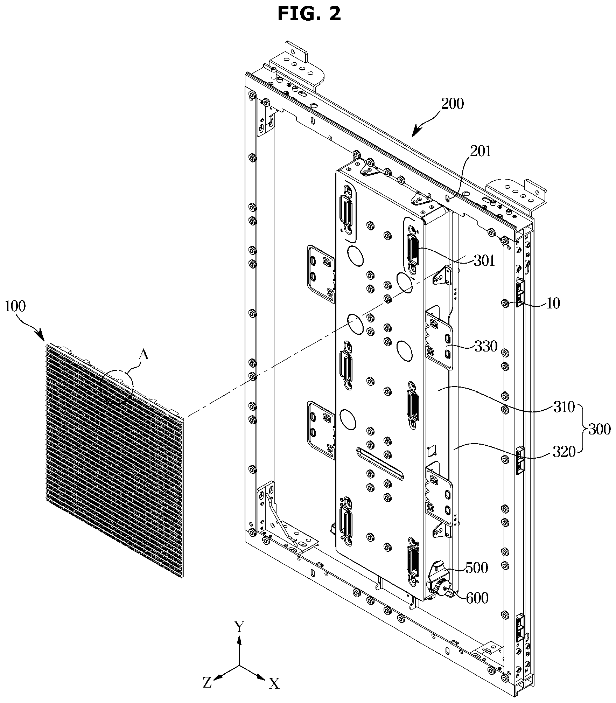

FIG. 1 is a perspective view of a display apparatus according to an embodiment. FIG. 2 is an exploded perspective view of the display apparatus according to an embodiment. FIG. 2 is a view illustrating a cabinet and a display module separated from the cabinet, viewed from the front, in the display apparatus according to an embodiment.

FIG. 1 shows an X-axis, a Y-axis, and a Z-axis direction perpendicular to each other, wherein the X-axis direction may refer to a left-to-right direction, the Y-axis direction may refer to an up-and-down direction, and the Z-axis direction may refer to a front-to-back direction. However, the meanings of the X-axis, Y-axis, and Z-axis directions are not limited to the example described above and may be varied.

Referring to FIGS. 1 and 2, a display apparatus 1 is a device that displays information, materials, data, and the like in the form of characters, shapes, graphs, images, and the like, and a billboard, a signboard, a screen, a television, a monitors, and the like may be implemented as the display apparatus 1. The display apparatus 1 may be mounted on a wall or ceiling, or may be mounted on an indoor or outdoor ground by means of a stand (not shown).

The display apparatus 1 may include a display module 100 that displays a screen, a cabinet 200 coupled to a rear side of the display module 100 to support the display module 100, and a circuit case 300 coupled to the cabinet 200 and accommodating electrical components and/or printed circuit boards (PCBs) therein.

In the display apparatus 1 according to an embodiment, six display modules 100 may be coupled to one cabinet 200. Specifically, two display modules 100 may be coupled to one cabinet 200 in the left-to-right direction X, and three display modules 100 may be coupled in the up-and-down direction Y. In other words, the display modules 100 may be coupled to the cabinet 200 in a 2 * 3 matrix. However, the number of display modules 100 coupled to the cabinet 200 is not limited. Two or more display modules 100 may be coupled to one cabinet 200.

Referring to FIG. 1, the display apparatus 1 according to an embodiment may include eight cabinets 200 and 48 display modules 100 coupled to the eight cabinets 200. As such, the display apparatus 1 may realize a large-sized screen by arranging a plurality of cabinets 200, to which a plurality of display modules 100 are coupled, adjacent to each other in the left-to-right direction X and the up-and-down direction Y. The number of the plurality of cabinets 200 arranged adjacent to each other in the left-to-right direction X and the up-and-down direction Y is not limited, and as described above, the number of the plurality of display modules 100 coupled to the cabinet 200 is also not limited.

Referring to FIG. 2, the display module 100 may be detachably coupled to the cabinet 200. The display module 100 may be detachable from the cabinet 200 toward a front side of the cabinet 200.

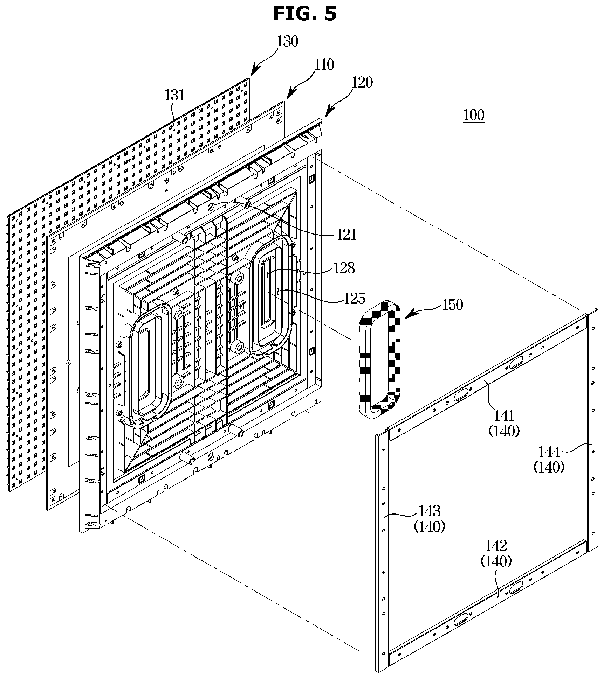

The display module 100 may be coupled to the cabinet 200 by magnetic forces. The cabinet 200 and the circuit case 300 may include a plurality of magnets 10 arranged on the front thereof. The plurality of magnets 10 may include a plurality of first magnets 10 arranged on a front surface of the cabinet 200. The plurality of magnets 10 may include a plurality of second magnets 10 arranged on a front surface of the circuit case 300. The display module 100 may include a reinforcing member 140 (see FIG. 5) arranged on a rear side thereof and coupled by magnetic attraction to the plurality of first magnets 10 and the plurality of second magnets 10. The plurality of first magnets 10 arranged on the cabinet 200 and the plurality of second magnets 10 arranged on the circuit case 300 may be of the same configuration as each other. The plurality of first magnets 10 and the plurality of second magnets 10 may be collectively referred to as the plurality of magnets 10.

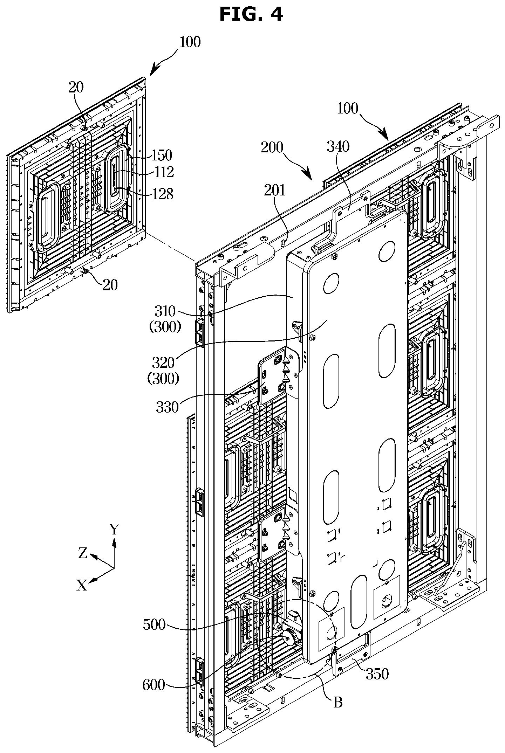

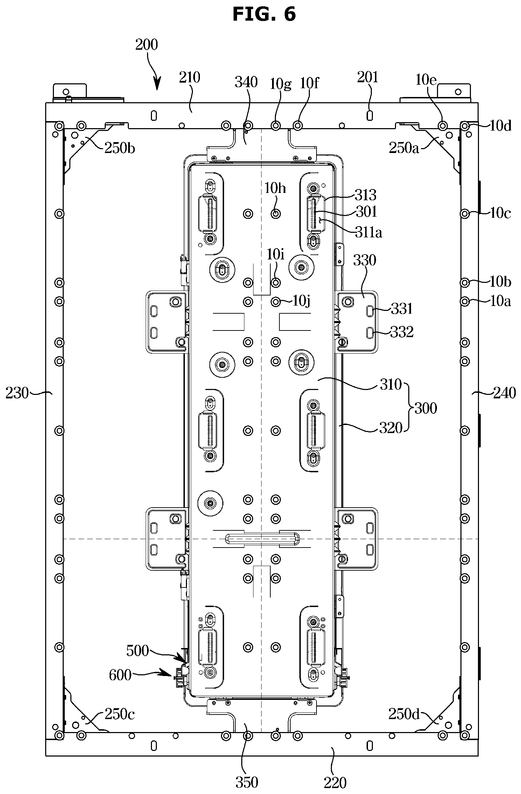

The cabinet 200 may include frames 210, 220, 230 and 240 (see FIG. 6) forming an outer edge of the cabinet 200. The circuit case 300 may be disposed inside the frames 210, 220, 230 and 240. The circuit case 300 may include a second connector 301 corresponding to a first connector 112 (see FIG. 4) included in each of the plurality of display modules 100. The circuit case 300 may include a first case 310 having a hexahedral shape with an open side, and a second case 320 arranged to cover the open side of the first case 310.

The plurality of display modules 100 may be electrically connected to each other by coupling the first connector 112 of each of the plurality of display modules 100 and the second connectors 301 of the circuit case 300. In addition, the plurality of display modules 100 may receive power from a power supply device disposed inside the circuit case 300.

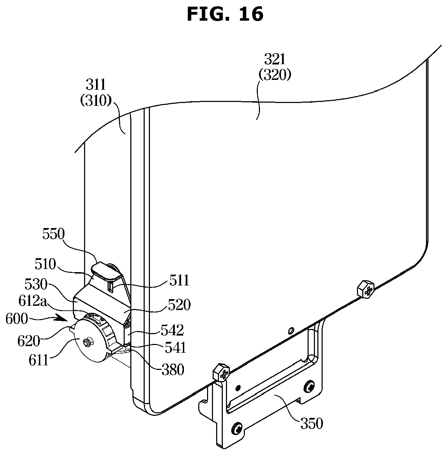

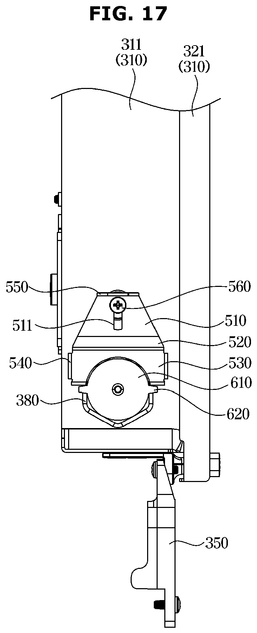

The display apparatus according to an embodiment may further include a locking member 500 coupled to the circuit case 300. When a cover 600 or 720 is coupled or mounted to a power connector 360, which will be described later, the locking member 500 may lock the cover 600 or 720 to prevent from being removed from the power connector 360 (see FIGS. 16, 17, and 22).

The display apparatus according to an embodiment may further include a connector cover 600. The connector cover 600 may cover the power connector 360, which will be described later.

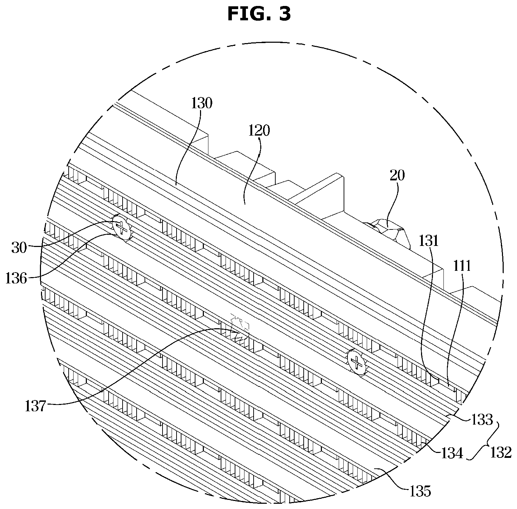

FIG. 3 is a partially enlarged view of the display apparatus of FIG. 2. FIG. 3 is an enlarged view of region 'A' of FIG. 2.

Referring to FIG. 3, the display module 100 may include a substrate 110 (see FIG. 5) and a holder 120 that covers the sides and rear of the substrate 110 and supports the substrate 110. The substrate 110 may be attached to a front surface of the holder 120 via an adhesive, double-sided adhesive tape, or the like, or may be coupled to the holder 120 via a fastening member such as a screw.

A plurality of light-emitting diodes (LEDs) 111 may be mounted on a front surface of the substrate 110. The substrate 110 may be formed of a material, such as glass, polyimide (PI), frame retardant 4 (FR4), or the like.

Each of the plurality of LEDs 111 may include a red LED, a green LED, and a blue LED packaged into a single pixel. The plurality of LEDs 111 may be mounted on the substrate 110 in a matrix form. The plurality of LEDs 111 may be arranged to have a certain spacing, and the spacing between the plurality of LEDs 111 may be varied depending on the resolution and size of the display apparatus 1.

The display module 100 may include a cover plate 130 configured to cover the front side of the substrate 110. The cover plate 130 may include a plurality of LED holes 131 each corresponding to the plurality of LEDs 111 mounted on the substrate 110. The plurality of LED holes 131 may allow the plurality of LEDs 111 to be exposed on a front surface of the cover plate 130.

The substrate 110 may be received within the cover plate 130 and the holder 120. The cover plate 130 and the holder 120 may be coupled together to form an internal space that receives the substrate 110.

The cover plate 130 may include a louver portion 132. The louver portion 132 may include a horizontal louver portion 133 and a vertical louver portion 134. The louver portion 132 may reduce or block moisture from entering the plurality of LEDs 111. In addition, the cover plate 130 may include a roof portion 135 arranged on an upper side of the plurality of LEDs 111. The roof portion 135 may protrude forwardly from the cover plate 130 to prevent water from directly entering the plurality of LEDs 111 from above.

The cover plate 130 may include a fastening hole 136 into which a fastening member 30 for coupling the cover plate 130, the substrate 110, and the holder 120 is inserted, and a fixing hole 137 into which a fixing member 20 is inserted.

FIG. 4 is a rear exploded perspective view of the display apparatus according to an embodiment. FIG. 4 is a rear view illustrating the cabinet and the display module separated from the cabinet in the display apparatus according to an embodiment. FIG. 5 is a rear exploded perspective view of the display module in the display apparatus according to an embodiment.

Referring to FIGS. 4 and 5, the display module 100 may be detachable toward the front side of the cabinet 200. When a force greater than or equal to the magnetic attraction between the cabinet 200 and the display module 100 is applied to the display module 100 in a direction opposite to the magnetic attraction, the display module 100 may be detached from the cabinet 200.

As described above, the display module 100 may be coupled to the cabinet 200 by magnetic forces. The plurality of magnets 10 (see FIG. 2) may be arranged on the front surface of the cabinet 200, and the reinforcing member 140, which is attracted by the magnetic attraction of the plurality of magnets 10, may be arranged on the rear side of the display module 100.

The reinforcing member 140 may be coupled to the rear side of the holder 120. The reinforcing member 140 may be disposed on an edge of the rear surface of the holder 120. The reinforcing member 140 may include a first reinforcing member 141, a second reinforcing member 142, a third reinforcing member 143, and a fourth reinforcing member 144. The first reinforcing member 141 may be disposed adjacent to an upper edge of the rear surface of the holder 120 and may extend in a horizontal direction. The second reinforcing member 142 may be disposed adjacent to a lower edge of the rear surface of the holder 120 and may extend in the horizontal direction. The third reinforcing member 143 may be disposed adjacent to a left edge of the rear surface of the holder 120 and may extend in a vertical direction. The fourth reinforcing member 144 may be disposed adjacent to a right edge of the rear surface of the holder 120 and may extend in the vertical direction.

The reinforcing member 140 may increase the strength of the display module 100 by being coupled to the rear surface of the holder 120. The reinforcing member 140 may prevent the display module 100 from warping. The reinforcing member 140 may prevent physical deformation of the display module 100.

The reinforcing member 140 may be formed of a material that is attracted by the magnetic force of the magnets 10. The reinforcing member 140 may be formed of a material that is magnetizable by an external magnetic force. The reinforcing member 140 may be attracted to the magnet 10 and to each other by the polarity acquired by the reinforcing member 140 from the external magnetic force. The reinforcing member 140 may be configured to include a magnetic material that interacts with the magnets 10. For example, the reinforcing member 140 may include iron (Fe).

The display module 100 may include the fixing member 20. The fixing member 20 may be disposed one at a rear upper side and one at a rear lower side of the display module 100. However, the positions of the fixing member 20 are not limited to those shown.

The display module 100 may include a first connector hole 128 that exposes the first connector 112, arranged on the rear side of the substrate 110, to the rear side of the display module 100. A sealing groove 125 for sealing the first connector hole 128 may be formed in the holder 120, and a sealing member 150 may be arranged in the sealing groove 125.

The sealing member 150 may be arranged to correspond to the shape of the sealing groove 125. The sealing member 150 may be provided in an approximately ring shape. The sealing member 150 may be made of a material capable of volume change, and may be configured to include, for example, rubber.

According to an embodiment, the sealing member 150 may be attached to the rear surface of the display module 100, but is not limited thereto. The sealing member 150 may also be attached to the front surface of the circuit case 300 so as to correspond to the sealing groove 125.

According to an embodiment, the fixing member 20 may be provided in the form of a wing nut. The fixing member 20 may be insertable into a holder hole 121 of the holder 120.

FIG. 6 is a front view of a cabinet in the display apparatus according to an embodiment.

Referring to FIG. 6, the cabinet 200 may be formed by coupling four frames 210, 220, 230 and 240 extending in one direction. The four frames 210, 220, 230 and 240 may be coupled to each other by four comer brackets 250a, 250b, 250c and 250d.

The frames 210, 220, 230 and 240 may include a first frame 210 forming an upper edge of the cabinet 200, a second frame 220 forming a lower edge of the cabinet 200, a third frame 230 forming a left edge of the cabinet 200, and a fourth frame 240 forming a right edge of the cabinet 200. The first frame 210 and the second frame 220 may be arranged in the horizontal direction, and the third frame 230 and the fourth frame 240 may be arranged in the vertical direction.

The first frame 210 and the fourth frame 240 may be coupled by the first comer bracket 250a. The first frame 210 and the third frame 230 may be coupled by the second comer bracket 250b. The second frame 220 and the third frame 230 may be coupled by the third corner bracket 250c, and the second frame 220 and the fourth frame 240 may be coupled by the fourth comer bracket 250d.

The first frame to the fourth frame 210, 220, 230 and 240 may be coupled to each other by the first comer bracket to the fourth comer bracket 250a, 250b, 250c and 250d to have a rectangular frame shape.

The circuit case 300 may be located at an inner center of the frames 210, 220, 230 and 240. The circuit case 300 may be coupled to the frames 210 and 220 by a first connection bracket 340 and a second connection bracket 350 arranged on upper and lower sides of the circuit case 300, respectively.

The circuit case 300 may include the first case 310 that forms the front and sides of the circuit case 300 and is open at the rear, and the second case 320 configured to cover the open rear of the first case 310. The first case 310 and the second case 320 may be coupled together to form the circuit case 300. The first case 310 and the second case 320 may be coupled together such that their interiors are hermetically sealed. The first case 310 and the second case 320 may be coupled together such that water ingress from the outside is blocked.

A second connector hole 311a may be arranged on a front side of the first case 310. The first case 310 may include a rib 313 arranged along a perimeter of the second connector hole 311a and protruding forward. The second connector 301 may be disposed inside the second connector hole 311a.

The second connector hole 311a, the second connector 301, and the rib 313 may be provided corresponding to the number of display modules 100 coupled to the cabinet 200.

A power supply device (not shown) for supplying power to the display module 100, a control board (not shown) for controlling the display module 100, and the like may be provided with the circuit case 300. In the present disclosure, the electrical components may include the power supply device, the control board, and various electronic components described above.

The circuit case 300 may include a support bracket 330 configured to support the display module 100. The support bracket 330 may be coupled to opposite sides of the circuit case 300. Furthermore, the support bracket 330 may be provided on each of the upper and lower sides on opposite sides of the circuit case 330. According to an embodiment, four support brackets 330 may be coupled to the circuit case 330.

The cabinet 200 may include the plurality of magnets 10. In addition, the circuit case 300 may include the plurality of magnets 10.

For example, the cabinet 200 may include the plurality of magnets 10 arranged to be spaced apart from each other on the front surfaces of the first frame to the fourth frame 210, 220, 230 and 240.

In addition, the circuit case 300 may include the plurality of magnets 10 arranged to be spaced apart from each other on the front side of the circuit case 300.

The cabinet 200 and the circuit case 300 according to an embodiment may include 10 magnets 10 per one display module 100. The cabinet 200 and the circuit case 300 may include a total of 60 magnets 10. The cabinet 200 may include 38 magnets 10, and the circuit case 300 may include 22 magnets 10. However, the number and location of the magnets 10 are not limited, and the number and location of the magnets 10 may be varied.

For example, to support the display module 100 coupled to the upper right side of the cabinet 200, the cabinet 200 may include first to seventh magnets 10a, 10b, 10c, 10d, 10e, 10f, and 10g, and the circuit case 300 may include eighth to tenth magnets 10h, 10i and 10j.

The plurality of magnets 10, as described above, may couple the display module 100 to the cabinet 200 by magnetically attracting the reinforcing member 140, which is made of a magnetizable material and disposed on the rear surface of the display module 100.

The display apparatus according to an embodiment may further include the locking member 500 coupled to the circuit case 300. When the cover 600 or 720 is coupled or mounted to the power connector 360, which will be described later, the locking member 500 may lock the cover 600 or 720 such that the cover 600 or 720 is not detached from the power connector 360 (see FIGS. 16, 17, and 22).

Although the locking member 500 is shown in the drawings as being coupled to a lower portion of a side wall 311 of the first case 310, the position of the locking member 500 may be varied depending on the position of the power connector 360. Thus, the locking member 500 may also be positioned on an upper portion of the side wall 311, a rear wall 321, or the like of the circuit case 300. However, for ease of description, the present disclosure illustrates that the power connector 360 is arranged on the side wall 311, and the locking member 500 is also disposed on the side wall 311.

The display apparatus according to an embodiment may further include the locking member 500 coupled to the circuit case 300. When the cover 600 or 720 is coupled or mounted to the power connector 360, which will be described later, the locking member 500 may lock the cover 600 or 720 to prevent the cover 600 or 720 from being detached from the power connector 360 (see FIGS. 16, 17, and 22).

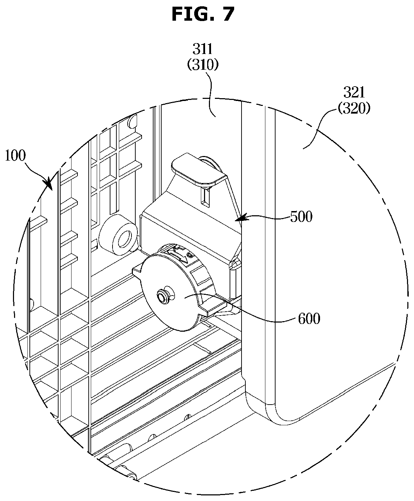

FIG. 7 is a partially enlarged view of the display apparatus according to an embodiment.

Referring to FIG. 7, the display apparatus according to an embodiment of the present disclosure may include the cover 600. The cover 600 may cover the power connector 360 arranged on one wall, such as the side wall 311 of the circuit case 300. For example, when the power connector 360 is attached to the side wall 311 of the circuit case 300, the cover 600 may cover the power connector 360 from the side wall 311 side of the circuit case 300.

By covering the power connector 360, the cover 600 may prevent water and/or foreign substances from entering the power connector 360 even when the display apparatus is installed outdoors, and may prevent wild animals from damaging the power connector 360. The cover 600 may be detachably coupled to the power connector 360. The cover 600 may be referred to as a cap cover 600.

The display apparatus according to an embodiment may include the locking member 500. The locking member 500 may lock the cap cover 600 covering the power connector 360 on the one wall 311 side of the circuit case 300. The locking member 500 may be coupled to the one wall 311 of the circuit case 300 in which the power connector 360 is provided, and when the cap cover 600 is coupled to the power connector 360, and may slide toward the cap cover 600 to lock the cap cover 600. For example, when the power connector 360 is attached to the side wall 311 of the circuit case 300, the locking member 500 may lock the cap cover 600 on the side wall 311 side of the circuit case 300. The locking member 500 may contact the cap cover 600 to prevent the cap cover 600 from rotating.

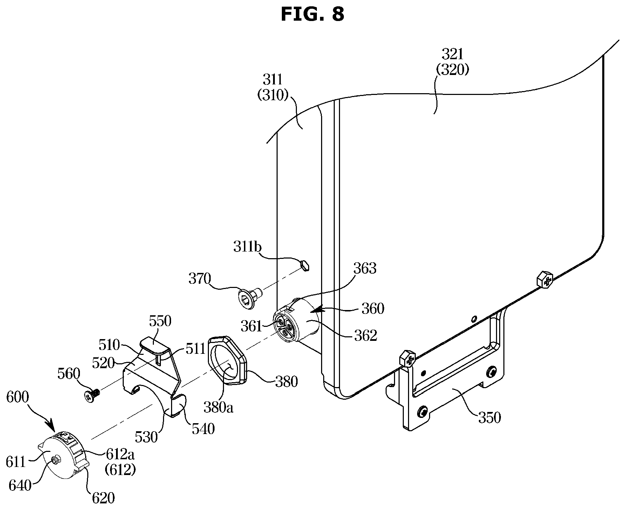

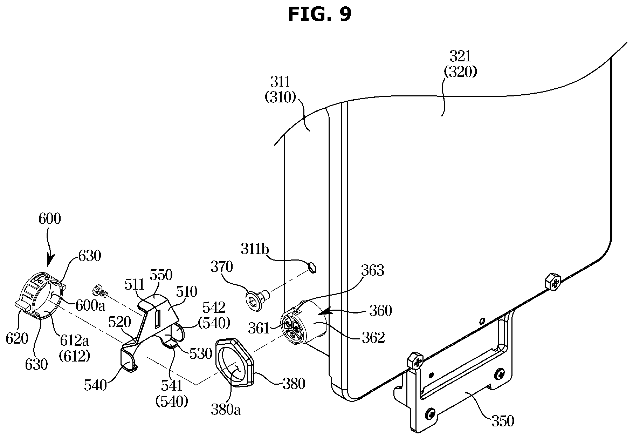

FIGS. 8 and 9 are exploded perspective views of some configurations of the display apparatus shown in FIG. 7.

Referring to FIGS. 8 and 9, the display apparatus according to an embodiment may include the power connector 360 attached to the one wall 311 of the circuit case 300. For example, the power connector 360 may be disposed on the side wall 311 of the circuit case 300. The power connector 360 may also be provided in a plurality. For example, the power connectors 360 may be provided on each of both side walls 311 of the circuit case 300. However, the arrangement of the power connector 360 is not limited to the examples described above, and may also be arranged on the rear wall 321 or a lower wall 312.

The power connector 360 may include a connecting portion 361 and an outer wall 362. The connecting portion 361 may be electrically connected to a wire conduit 700 (or an electrical wire conduit). The connecting portion 361 may include a connecting groove 361a for connection with the wire conduit 700. However, the present disclosure is not limited thereto, and a connecting protrusion may be formed in the connecting portion 361. The outer wall 362 may surround the connecting portion 361. The outer wall 362 may protect the connecting portion 361.

A mounting recess 363 may be formed on the outer wall 362 of the power connector 360. The mounting recess 363 may be formed such that a mounting protrusion 630 formed on the cap cover 600 may be mountable when the cap cover 600 is primarily locked to the power connector 360. For example, the mounting recess 363 may be formed on an upper and/or lower portion of the outer wall 362. The location, number, and shape of the mounting recess 363 are not limited to the examples described above.

The display apparatus according to an embodiment may include a first fixing member 380. The first fixing member 380 may allow the power connector 360 to be held to the one wall 311 of the circuit case 300. For example, the power connector 360 may be fitted into a fixing hole 380a of the first fixing member 380. The outer wall 362 of the power connector 360 may be fitted into the fixing hole 380a. The first fixing member 380 may function as a nut.

The display apparatus according to an embodiment may include the locking member 500. When the cap cover 600 or the wire conduit 700 is coupled to the power connector 360, the locking member 500 may lock the cap cover 600 or the wire conduit 700 to prevent the cap cover 600 or the wire conduit 700 from being rotated and detached.

The locking member 500 may include a fastening portion 510. The fastening portion 510 may be coupled to the one wall 311 of the circuit case 300 where the power connector 360 is positioned. The fastening portion 510 may be fastened to the one wall 311 of the circuit case 300 via a second fixing member 370 and a screw 560. The fastening portion 510 may be provided with a fastening hole 511. For example, the second fixing member 370 may penetrate the fastening hole 511, and the second fixing member 370 may be inserted into a fixing hole 311b formed in the side wall 311 of the circuit case 300 to attach the locking member 500 to the circuit case 300. The fastening hole 511 may extend in one direction. For example, the fastening hole 511 may extend in the up-and-down direction.

The fastening portion 510 may allow the locking member 500 to slide. For example, the locking member 500 may slide along the fastening hole 511 formed in the fastening portion 510. For example, the fastening portion 510 may slide in the up-and-down direction. The sliding direction of the fastening portion 510 is not limited to the example described above. The fastening portion 510 may be a sliding portion. The fastening hole 511 may be a sliding hole.

The locking member 500 may include an inclined portion 520. The inclined portion 520 may extend from the fastening portion 510. The inclined portion 520 may be inclined in a direction away from the side wall 311 of the circuit case 300 from the fastening portion 510. For example, the inclined portion 520 may be formed to be inclined downwardly from the fastening portion 510. The inclined portion 520 may extend to connect with the locking portion 530. One end of the inclined portion 520 may be connected to the fastening portion 510, and the other end may be connected to the locking portion 530.

The locking member 500 may include the locking portion 530. The locking portion 530 may extend from the inclined portion 520 to lock the cap cover 600 or the wire conduit 700. The locking portion 530 may be contactable with the cap cover 600 or the wire conduit 700 to prevent rotation of the cap cover 600 or the wire conduit 700. For example, the locking portion 530 may contact a retaining protrusion 620 of the cap cover 600 or a retaining protrusion 720 of the wire conduit 700 to prevent the cap cover 600 or the wire conduit 700 from rotating. The locking portion 530 may be connected to the inclined portion 520 on a side far from the side wall 311.

A bent portion 540 may include a contact portion 541. The contact portion 541 may be bent and extend from the locking portion 530. When the locking member 500 is coupled to the side wall 311, the contact portion 541 may extend from the locking portion 530 toward the side wall 311 of the circuit case 300. The contact portion 541 may be spaced apart from the side wall 311 of the circuit case 300 by a given distance to prevent the side wall 311 of the circuit case 300 from being scratched when the locking member 500 slides.

The contact portion 541 may extend from a lower end of the locking portion 530 toward the side wall 311. The contact portion 541 may stably prevent the cap cover 600 or the wire conduit 700 from rotating by making surface contact with the retaining protrusion 620 of the cap cover 600 or the retaining protrusion 720 of the wire conduit 700.

The bent portion 540 may include a reinforcing portion 542. The reinforcing portion 542 may be bent and extend from the locking portion 530. When the locking member 500 is coupled to the side wall 311, the reinforcing portion 542 may extend from the locking portion 530 toward the side wall 311 of the circuit case 300. The reinforcing portion 542 may be spaced apart from the side wall 311 of the circuit case 300 by a given distance to prevent the side wall 311 of the circuit case 300 from being scratched when the locking member 500 slides.

The reinforcing portion 542 may extend from both side ends of the locking portion 530 toward the side wall 311. The reinforcing portion 542 may add the strength of the locking member 500. For example, the reinforcing portion 542 may increase the strength of the contact portion 541 that contacts the retaining protrusion 620 of the cap cover 600 or the retaining protrusion 720 of the wire conduit 700. The reinforcing portion 542 may also function as a handle when the locking member 500 is to be moved by a user.

One of the contact portion 541 and the reinforcing portion 542 included in the bent portion 540 may be eliminated.

The locking member 500 may further include a handle 550. The handle 550 of the locking member 500 may be arranged at one end of the locking member 500. For example, the handle 550 of the locking member 500 may be formed on an upper end of the locking member 500. The handle 550 of the locking member 500 may be connected to the fastening portion 510. The user may utilize the handle 550 of the locking member 500 to slide the locking member 500. The handle 550 of the locking member 500 may extend from the fastening portion 510 in a direction away from the side wall 311.

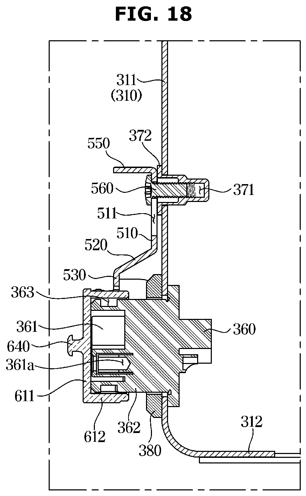

The display apparatus according to an embodiment may further include the second fixing member 370. The second fixing member 370 may allow the locking member 500 to be coupled to the one wall 311 of the circuit case 300. For example, the second fixing member 370 may allow the locking member 500 to be fastened to the side wall 311 of the circuit case 300. The second fixing member 370 may be inserted into the fixing hole 311b formed in the side wall 311. The screw 560 may be inserted into a fixing portion 371 of the second fixing member 370 (see FIG. 18).

The display apparatus according to an embodiment may further include the screw 560. The screw 560 may allow the locking member 500 to be coupled to the one wall 311 of the circuit case 300. For example, the screw 560 may allow the locking member 500 to be fastened to the side wall 311 of the circuit case 300. The screw 560 may be inserted into the fastening hole 511 formed in the locking member 500 and the fixing portion 371 formed in the second fixing member 370 to allow the locking member 500 to be secured to the side wall 311 of the circuit case 300. The locking member 500 may be slidably moved in a state of being secured to the side wall 311 by the screw 560.

The display apparatus according to an embodiment of the present disclosure may include the cap cover 600. The cap cover 600 may cover the power connector 360 when the wire conduit 700 is not coupled to the power connector 360. The cap cover 600 may be releasably coupled to the power connector 360.

The cap cover 600 may include a cover portion 610. The cover portion 610 may form an exterior of the cap cover 600 such that the power connector 360 is received within the cap cover 600. A receiving portion 600a may be formed inside the cap cover 600 to receive the power connector 360.

The cover portion 610 may include a first cover portion 611 and a second cover portion 612. When the cap cover 600 is coupled to the power connector 360, the first cover portion 611 may be disposed in line with the side wall 311 of the circuit case 300. The first cover portion 611 may cover the connecting portion 361. The second cover portion 612 may extend from a perimeter of the first cover portion 611 toward the side wall 311. The second cover portion 612 may be formed corresponding to the outer wall 362 of the power connector 360. The second cover portion 612 may have an inner surface 612b and an outer surface 612a.

The cap cover 600 may include the mounting protrusion 630. The mounting protrusion 630 may protrude from the inner surface 612b of the cover portion 610 and be mounted to the power connector 360. For example, the mounting protrusion 630 may protrude from the inner surface 612b of the second cover portion 612. When the cap cover 600 is primarily locked to the power connector 360, the mounting protrusion 630 may be mounted in the mounting recess 363. The mounting protrusions 630 may be provided in a plurality.

The cap cover 600 may include the retaining protrusion 620. The retaining protrusion 620 may protrude from the outer surface 612a of the cover portion 610 and be retained and secondarily locked by the locking member 500. For example, the retaining protrusion 620 protrudes from the outer surface 612a of the second cover portion 612. After the cap cover 600 is primarily locked to the power connector 360, the cap cover 600 may be secondarily locked as the locking member 500 slides to contact the mounting protrusion 630 and the locking portion 530. The retaining protrusions 620 may be provided in a plurality. The retaining protrusion 620 may protrude from the outer surface 612a of the second cover portion 612 on both sides.

The cap cover 600 may include a handle 640. The handle 640 of the cap cover 600 may be formed on the first cover portion 611. The handle 640 of the cap cover 600 may protrude from the first cover portion 611 in a direction away from the side wall 311 to allow the user to easily move the cap cover 600.

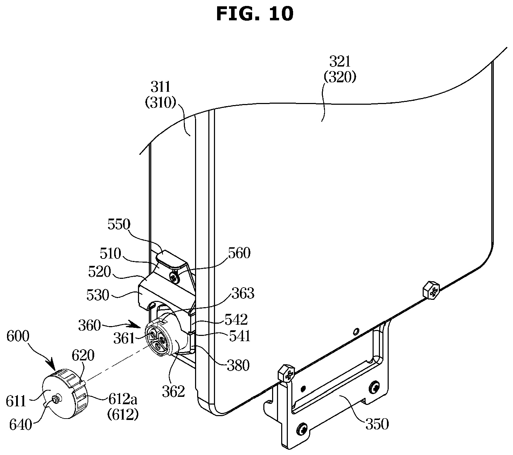

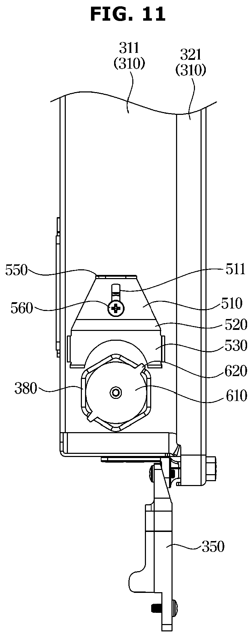

FIGS. 10 to 17 are views illustrating a process in which the locking member locks the cover in the display apparatus according to an embodiment. FIGS. 10, 12, 14, and 16 are perspective views, and FIGS. 11, 13, 15, and 17 are side views. FIG. 18 is a side cross-sectional view of the display apparatus according to an embodiment.

Referring to FIGS. 10 and 11, in the display apparatus according to an embodiment, the cap cover 600 may be moved toward the side wall 311 to be coupled to the power connector 360.

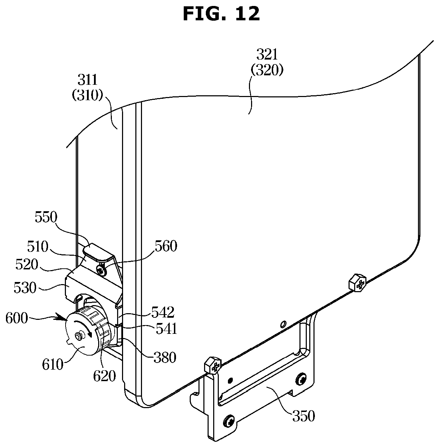

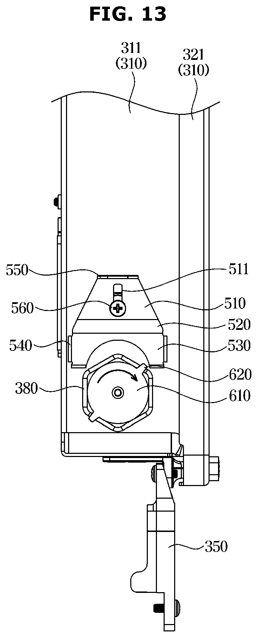

FIGS. 12 and 13 illustrate that the cap cover 600 is coupled to the power connector 360. At this time, the cap cover 600 may be positioned in a first position, which is a position before being rotated. Once the cap cover 600 is coupled to the power connector 360, the cap cover 600 may be rotated. For example, the cap cover 600 may be rotated in a first direction to be primarily locked to the power connector 360.

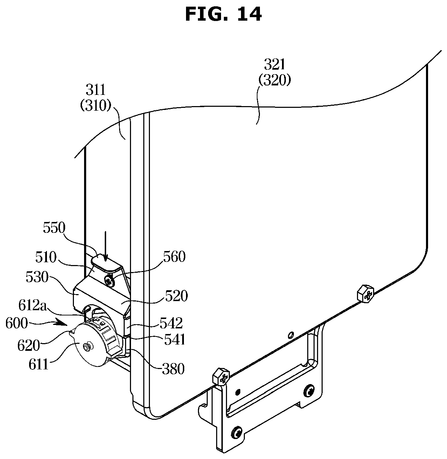

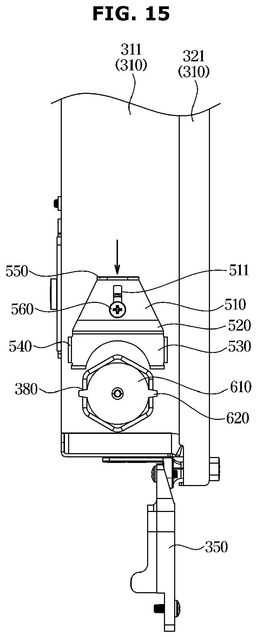

Referring to FIGS. 14 and 15, the cap cover 600 may be in a state in which the mounting protrusion 630 and the mounting recess 363 are coupled by rotation of the cap cover 600. The rotated position of the cap cover 600 may be a second position. In the second position, the cap cover 600 may be primarily locked. For example, the user may primarily lock the cap cover 600 to the power connector 360 by grasping the handle 640 and/or the cover portion 610 of the cap cover 600 and rotating the cap cover 600. After the cap cover 600 is primarily locked to the power connector 360, the locking member 500 may slide downward to secondarily lock the cap cover 600 to prevent the primary locking of the cap cover 600 from being released. For example, the locking member 500 may slide toward the cap cover 600 to secondarily lock the cap cover 600 to prevent the cap cover 600 from rotating in a second direction opposite to the first direction. For example, the user may slide the locking member 500 by pushing the handle 550 of the locking member 500 downward. Alternatively, the user may move the locking member 500 by grasping the reinforcing portion 542. At this point, the screw 560 may be slightly loosened from the second fixing member 370.

Referring to FIGS. 16 to 18, the cap cover 600 may be secondarily locked as the locking member 500 is moved toward the cap cover 600. The contact portion 541 may contact the retaining protrusion 620 protruding from the cap cover 600 to prevent the locking member 500 from rotating in the second direction. At this point, the screw 560 may be tightened and fully engaged with the second fixing member 370. The screw 560 may be tightened or loosened using a tool, such as a screwdriver, rather than the user's hand.

In the display apparatus according to an embodiment, the cap cover 600 may be coupled to the power connector 360 coupled to the side wall 311, and the locking member 500 may press the cap cover 600 at the perimeter of the cap cover 600 to prevent the cap cover 600 from rotating.

To remove the cap cover 600, the process described above may be performed in reverse order. For example, the screw 560 may be slightly loosened by using a screwdriver, the locking member 500 may be slid upward, and then the cap cover 600 may be rotated in the second direction, thereby releasing the cap cover 600 from the power connector 360.

Meanwhile, the second fixing member 370 may be inserted through the side wall 311 of the circuit case 300. The second fixing member 370 may be inserted into the fixing hole 311b formed in the one wall 311.

The screw 560 may be inserted into the fixing portion 371 of the second fixing member 370.

The second fixing member 370 may further include a supporting portion 372. The supporting portion 372 may support the locking member 500 when the locking member 500 is coupled to the side wall 311 via the screw 560. The supporting portion 372 may prevent the locking member 500 from directly contacting the circuit case 300. The supporting portion 372 may be disposed between the side wall 311 of the circuit case 300 and the locking member 500.

As described above, according to an embodiment of the present disclosure, the cap cover 600 connected to the power connector 360 may be securely locked. As a result, the user cannot manually remove the cap cover 600, thereby satisfying the safety standards. Nevertheless, the simple structure described above may allow for easy removal, providing the advantage of improving workability.

In addition, when power-related repairs within the display module 100 are needed, the cap cover 600 connected to the power connector 360 may be simply removed using only a tool such as a screwdriver.

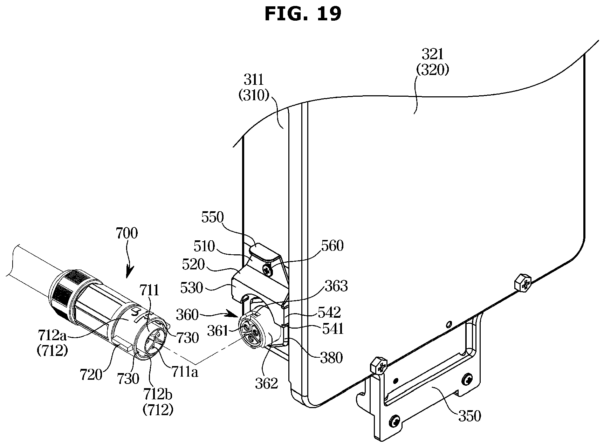

FIGS. 19 to 22 are views illustrating a process in which the locking member locks the cover in the display apparatus according to an embodiment.

Referring to FIGS. 19 to 22, the display apparatus according to an embodiment may further include the wire conduit 700. The wire conduit 700 may be connected to the circuit case 300 to supply power to the display module 100. For example, the wire conduit 700 may be coupled to the power connector 360 arranged on the side wall 311 of the circuit case 300.

The wire conduit 700 may include a wire conduit connecting portion 711. The wire conduit connecting portion 711 may be arranged to correspond to the connecting portion 361 of the power connector 360. The wire conduit connecting portion 711 may include a connecting protrusion 711a. The connecting protrusion 711a may be inserted into the connecting groove 361a arranged in the connecting portion of the power connector 360 (see FIG. 18). The connecting protrusion 711a and the connecting groove 361a may be formed corresponding to each other. Conversely, it is also possible that a connecting groove is formed in the wire conduit connecting portion 711, and a connecting protrusion is formed on the power connector 360.

The wire conduit 700 may further include a wire conduit cover 712. The wire conduit cover 712 may cover the wire conduit connecting portion 711. For example, the wire conduit cover 712 may cover a perimeter of the wire conduit connecting portion 711. The wire conduit cover 712 may be formed corresponding to a perimeter of the wire conduit connecting portion 711. The wire conduit cover 712 may include an inner surface 712b and an outer surface 712a.

The wire conduit cover 712 may include a mounting protrusion 730. The mounting protrusion 730 may protrude from the inner surface 712b of the wire conduit cover 712 and be mounted to the power connector 360. When the wire conduit cover 712 is primarily locked to the power connector 360, the mounting protrusion 730 may be mounted in the mounting recess 363. The mounting protrusion 730 may be provided in a plurality.

The wire conduit cover 712 may include the retaining protrusion 720. The retaining protrusion 720 may protrude from the outer surface 712a of the wire conduit cover 712 and be retained and secondarily locked by the locking member 500. After the wire conduit cover 712 is primarily locked to the power connector 360, the wire conduit cover 712 may be secondarily locked as the locking member 500 slides to contact the mounting protrusion 730 and the locking portion 530. The retaining protrusions 720 may be provided in a plurality. The retaining protrusion 720 may protrude from the outer surface 712a of the wire conduit cover 712 on both sides.

Referring to FIG. 19, in the display apparatus according to an embodiment, the wire conduit 700 may be moved toward the side wall 311 to be coupled to the power connector 360.

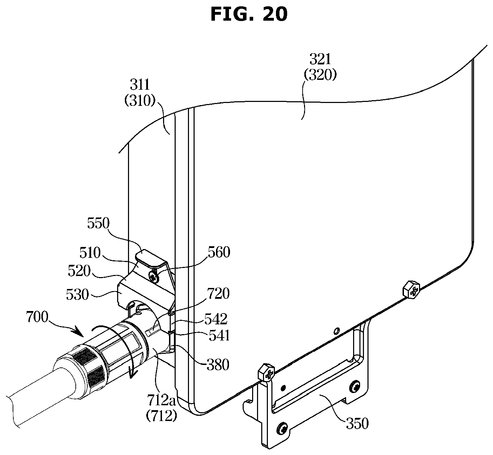

Referring to FIG. 20, the wire conduit 700 may be coupled to the power connector 360. At this time, the wire conduit cover 712 may be positioned in a first position, which is a position before being rotated. Once the wire conduit cover 712 is coupled to the power connector 360, the wire conduit cover 712 may be rotated. For example, the wire conduit cover 712 may be rotated in a first direction to be primarily locked to the power connector 360.

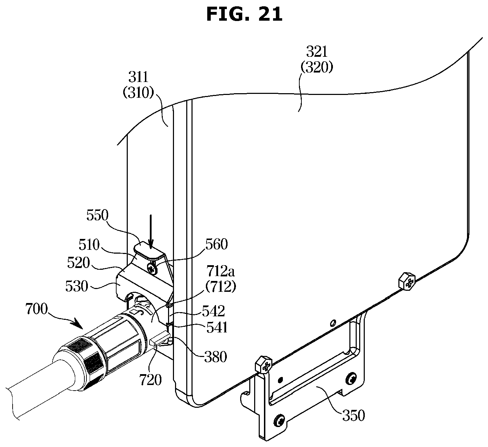

Referring to FIG. 21, the wire conduit cover 712 may be in a state in which the mounting protrusion 730 and the mounting recess 363 are coupled by rotation of the wire conduit cover 712. The rotated position of the wire conduit cover 712 may be a second position. In the second position, the wire conduit cover 712 may be primarily locked. For example, the user may primarily lock the wire conduit cover 712 to the power connector 360 by grasping the wire conduit cover 712 and rotating the wire conduit cover 712. After the wire conduit cover 712 is primarily locked to the power connector 360, the locking member 500 may slide downward to secondarily lock the wire conduit cover 712 to prevent the primary locking of the wire conduit cover 712 from being released. For example, the locking member 500 may slide toward the wire conduit cover 712 to secondarily lock the wire conduit cover 712 to prevent the wire conduit cover 712 from rotating in a second direction opposite to the first direction. For example, the user may slide the locking member 500 by pushing the handle 550 of the locking member 500 downward. Alternatively, the user may move the locking member 500 by grasping the reinforcing portion 542. At this point, the screw 560 may be slightly loosened from the second fixing member 370.

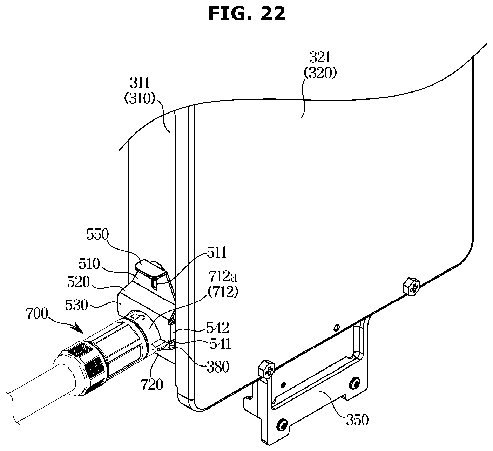

Referring to FIG. 22, the wire conduit cover 712 may be secondarily locked as the locking member 500 is moved toward the wire conduit cover 712. The contact portion 541 may contact the retaining protrusion 720 protruding from the wire conduit cover 712 to prevent the locking member 500 from rotating in the second direction. At this point, the screw 560 may be tightened and completely engaged with the second fixing member 370. The screw 560 may be tightened or loosened using a tool such, as a screwdriver, rather than the user's hand.

In the display apparatus according to an embodiment, the wire conduit 700 may be coupled to the power connector 360 coupled to the side wall 311, and the locking member 500 may press the wire conduit cover 712 at the perimeter of the wire conduit cover 712 to prevent the wire conduit cover 712 from rotating.

To remove the wire conduit cover 712, the process described above may be performed in reverse order. For example, the screw 560 may be slightly loosened by using a screwdriver, the locking member 500 may be slid upward, and then the wire conduit cover 712 may be rotated in the second direction, thereby releasing the wire conduit 700 from the power connector 360.

Although certain example embodiments are illustrated and described above, the present disclosure is not limited to the certain embodiments, various applications may of course be performed by those skilled in the art without deviating from what is claimed in the scope of claims, and such applications should not be understood separately from the technical idea or prospects herein.

## Claims

1. A display apparatus (1) comprising:
a display module (100);
a cabinet (200) to which the display module is coupled;
a circuit case (300) coupled to the cabinet and receiving a printed circuit board;
a power connector (360) arranged on one wall (311) of the circuit case to supply power to the printed circuit board; **characterized in that** the display apparatus further comprises:
a cover (600) detachably coupled to the power connector; and
a locking member (500) coupled to the one wall of the circuit case on which the power connector is arranged, and configured to lock the cover by preventing rotation of the cover in a state in which the cover is coupled to the power connector.

2. The display apparatus of claim 1, wherein the locking member slides toward the cover to contact the cover so as to prevent the rotation of the cover when the cover is coupled to the power connector.

3. The display apparatus of claim 2, wherein the locking member comprises:
a fastening portion (510) fastened to the one wall of the circuit case, and
a locking portion (530) connected to the fastening portion, and contactable with the cover to prevent the rotation of the cover.

4. The display apparatus of claim 3, wherein the cover comprises:
a cover portion (610) formed corresponding to the power connector to receive the power connector in a state in which the cover is coupled to the power connector, and
a retaining protrusion (620) protruding from an outer surface of the cover portion to be contactable with the locking portion so as to prevent the rotation of the cover.

5. The display apparatus of claim 4, wherein the cover portion comprises:
a first cover portion (611) in line with the one wall in a state in which the cover is coupled to the power connector, and
a second cover portion (612) extending from the first cover portion to cover a perimeter of the power connector, and
wherein the retaining protrusion protrudes from an outer surface (612a) of the second cover portion.

6. The display apparatus of claim 5, further comprising a screw (560) inserted into the one wall through the fastening portion to allow the locking member to be fastened to the one wall of the circuit case,
wherein the locking member is slidable relative to the screw to lock the cover.

7. The display apparatus of claim 6, wherein the locking member further comprises an inclined portion (520) inclined from the fastening portion toward the locking portion in a direction away from the one wall.

8. The display apparatus of claim 7, wherein
the cover is rotated in a first direction to be primarily locked to the power connector when the cover is coupled to the power connector, and
the locking member slides toward the cover to contact the cover to secondarily lock the cover so as to prevent the cover from rotating in a second direction opposite to the first direction.

9. The display apparatus of claim 8, wherein the cover further comprises a mounting protrusion (630) protruding from an inner surface (612b) of the second cover portion such that the cover is primarily locked to the power connector.

10. The display apparatus of claim 9, wherein the power connector comprises:
a connecting portion (361),
an outer wall (362) covering a perimeter of the connecting portion, and
a mounting recess (363) formed on the outer wall such that the mounting protrusion is mountable in a state in which the cover is primarily locked to the power connector.

11. The display apparatus of claim 1, further comprising a wire conduit (700) connectable to the power connector to supply power to the display module from an outside,
wherein the wire conduit comprises:
a wire conduit connecting portion (711) connected to the power connector, and
a wire conduit cover (712) configured to cover a perimeter of the wire conduit connecting portion, and
wherein, in a state in which the cover is removed from the power connector, the wire conduit is coupled to the power connector and the locking member contacts the wire conduit cover to prevent rotation of the wire conduit cover.

12. The display apparatus of claim 11, wherein the locking member comprises:
a fastening portion (510) fastened to the one wall,
an inclined portion (520) inclined from the fastening portion in a direction away from the one wall, and
a locking portion (530) connected to the inclined portion on a side far from the one wall and contactable with the wire conduit cover to prevent the rotation of the wire conduit cover.

13. The display apparatus of claim 12, wherein the wire conduit cover comprises a retaining protrusion (620) protruding from an outer surface (612a) of the wire conduit cover to be contactable with the locking portion to prevent the rotation of the wire conduit cover.

14. The display apparatus of claim 13, wherein the wire conduit cover further comprises a fastening protrusion (510) protruding from an inner surface of the wire conduit cover such that the wire conduit cover is primarily locked to the power connector.

15. The display apparatus of claim 14, wherein
in a state in which the wire conduit and the power connector are connected to each other, the wire conduit cover is rotated in a first direction to be primarily locked to the power connector, and
the locking member slides toward the wire conduit cover to secondarily lock the wire conduit cover so as to prevent the wire conduit cover from rotating in a second direction opposite to the first direction.

## Patentansprüche

1. Anzeigegerät (1), umfassend:
ein Anzeigemodul (100);
einen Korpus (200), an den das Anzeigemodul gekoppelt ist;
ein Schaltungsgehäuse (300), das an den Korpus gekoppelt ist und eine Platine aufnimmt;
einen Stromanschluss (360), der auf einer Wand (311) des Schaltungsgehäuses angeordnet ist, um die Platine mit Strom zu versorgen; **dadurch gekennzeichnet, dass** das Anzeigegerät ferner umfasst:
eine Abdeckung (600), die abnehmbar an den Stromanschluss gekoppelt ist; und
ein Verriegelungselement (500), das an die eine Wand des Schaltungsgehäuses gekoppelt ist, worauf der Stromanschluss angeordnet ist, und dazu konfiguriert ist, die Abdeckung zu verriegeln, indem eine Drehung der Abdeckung in einem Zustand verhindert wird, in dem die Abdeckung an den Stromanschluss gekoppelt ist.

2. Anzeigegerät nach Anspruch 1, wobei das Verriegelungselement hin zu der Abdeckung gleitet, um die Abdeckung zu kontaktieren, um so die Drehung der Abdeckung zu verhindern, wenn die Abdeckung an den Stromanschluss gekoppelt ist.

3. Anzeigegerät nach Anspruch 2, wobei das Verriegelungselement umfasst:
einen Befestigungsabschnitt (510), der an der einen Wand des Schaltungsgehäuses befestigt ist, und
einen Verriegelungsabschnitt (530), der mit dem Befestigungsabschnitt verbunden ist und mit der Abdeckung kontaktierbar ist, um die Drehung der Abdeckung zu verhindern.

4. Anzeigegerät nach Anspruch 3, wobei die Abdeckung umfasst:
einen Abdeckungsabschnitt (610), der entsprechend dem Stromanschluss gebildet ist, um den Stromanschluss in einem Zustand aufzunehmen, in dem die Abdeckung an den Stromanschluss gekoppelt ist, und
einen Haltevorsprung (620), der von einer Außenfläche des Abdeckungsabschnitts vorsteht, um mit dem Verriegelungsabschnitt kontaktierbar zu sein, um so die Drehung der Abdeckung zu verhindern.

5. Anzeigegerät nach Anspruch 4, wobei der Abdeckungsabschnitt umfasst:
einen ersten Abdeckungsabschnitt (611) in einer Linie mit der einen Wand in einem Zustand, in dem die Abdeckung an den Stromanschluss gekoppelt ist, und
einen zweiten Abdeckungsabschnitt (612), der sich von dem ersten Abdeckungsabschnitt erstreckt, um einen Perimeter des Stromanschlusses abzudecken, und
wobei der Haltevorsprung von einer Außenfläche (612a) des zweiten Abdeckungsabschnitts vorsteht.

6. Anzeigegerät nach Anspruch 5, ferner umfassend eine Schraube (560), die in die eine Wand durch den Befestigungsabschnitt eingeführt wird, um zu ermöglichen, dass das Verriegelungselement an der einen Wand des Schaltungsgehäuses befestigt wird,
wobei das Verriegelungselement relativ zu der Schraube verschiebbar ist, um die Abdeckung zu verriegeln.

7. Anzeigegerät nach Anspruch 6, wobei das Verriegelungselement ferner einen geneigten Abschnitt (520) umfasst, der von dem Befestigungsabschnitt hin zu dem Verriegelungsabschnitt in einer Richtung weg von der einen Wand geneigt ist.

8. Anzeigegerät nach Anspruch 7, wobei
die Abdeckung in einer ersten Richtung gedreht wird, um primär an dem Stromanschluss verriegelt zu werden, wenn die Abdeckung an den Stromanschluss gekoppelt ist, und
das Verriegelungselement hin zu der Abdeckung gleitet, um die Abdeckung zu kontaktieren, um sekundär die Abdeckung zu verriegeln, um so zu verhindern, dass sich die Abdeckung in einer zweiten Richtung entgegengesetzt zu der ersten Richtung dreht.

9. Anzeigegerät nach Anspruch 8, wobei die Abdeckung ferner einen Montagevorsprung (630) umfasst, der von einer Innenfläche (612b) des zweiten Abdeckungsabschnitts vorsteht, sodass die Abdeckung primär an dem Stromanschluss verriegelt ist.

10. Anzeigegerät nach Anspruch 9, wobei der Stromanschluss umfasst:
einen Verbindungsabschnitt (361),
eine Außenwand (362), die einen Perimeter des Verbindungsabschnitts abdeckt, und
eine Montageaussparung (363), die auf der Außenwand gebildet ist, sodass der Montagevorsprung in einem Zustand montierbar ist, in dem die Abdeckung primär an dem Stromanschluss verriegelt ist.

11. Anzeigegerät nach Anspruch 1, ferner umfassend eine Drahtleitung (700), die mit dem Stromanschluss verbindbar ist, um das Anzeigemodul von einer Außenseite mit Strom zu versorgen,
wobei die Drahtleitung umfasst:
einen Drahtleitungsverbindungsabschnitt (711), der mit dem Stromanschluss verbunden ist, und
eine Drahtleitungsabdeckung (712), die dazu konfiguriert ist, einen Perimeter des Drahtleitungsverbindungsabschnitts abzudecken, und
wobei in einem Zustand, in dem die Abdeckung von dem Stromanschluss entfernt ist, die Drahtleitung an den Stromanschluss gekoppelt ist und das Verriegelungselement die Drahtleitungsabdeckung kontaktiert, um eine Drehung der Drahtleitungsabdeckung zu verhindern.

12. Anzeigegerät nach Anspruch 11, wobei das Verriegelungselement umfasst:
einen Befestigungsabschnitt (510), der an der einen Wand befestigt ist,
einen geneigten Abschnitt (520), der von dem Befestigungsabschnitt in einer Richtung weg von der einen Wand geneigt ist, und
einen Verriegelungsabschnitt (530), der auf einer Seite, die von der einen Wand fern ist, mit dem geneigten Abschnitt verbunden ist und mit der Drahtleitungsabdeckung kontaktierbar ist, um die Drehung der Drahtleitungsabdeckung zu verhindern.

13. Anzeigegerät nach Anspruch 12, wobei die Drahtleitungsabdeckung einen Haltevorsprung (620) umfasst, der von einer Außenfläche (612a) der Drahtleitungsabdeckung vorsteht, um mit dem Verriegelungsabschnitt kontaktierbar zu sein, um die Drehung der Drahtleitungsabdeckung zu verhindern.

14. Anzeigegerät nach Anspruch 13, wobei die Drahtleitungsabdeckung ferner einen Befestigungsvorsprung (510) umfasst, der von einer Innenfläche der Drahtleitungsabdeckung vorsteht, sodass die Drahtleitungsabdeckung primär an dem Stromanschluss verriegelt ist.

15. Anzeigegerät nach Anspruch 14, wobei
in einem Zustand, in dem die Drahtleitung und der Stromanschluss miteinander verbunden sind, die Drahtleitungsabdeckung in einer ersten Richtung gedreht wird, um primär an dem Stromanschluss verriegelt zu werden, und
das Verriegelungselement hin zu der Drahtleitungsabdeckung gleitet, um sekundär die Drahtleitungsabdeckung zu verriegeln, um so zu verhindern, dass sich die Drahtleitungsabdeckung in einer zweiten Richtung entgegengesetzt zu der ersten Richtung dreht.

## Revendications

1. Appareil d'affichage (1) comprenant :
un module d'affichage (100) ;
un coffre (200) auquel le module d'affichage est couplé ;
un boîtier de circuit (300) couplé au coffre et recevant une carte de circuit imprimé ;
un connecteur d'alimentation (360) agencé sur une paroi (311) du boîtier de circuit pour fournir de l'énergie à la carte de circuit imprimé ; **caractérisé en ce que** l'appareil d'affichage comprend en outre :
un couvercle (600) couplé de manière amovible au connecteur d'alimentation ; et
un élément de verrouillage (500) couplé à la paroi du boîtier de circuit sur laquelle le connecteur d'alimentation est agencé, et conçu pour verrouiller le couvercle en empêchant la rotation du couvercle dans un état dans lequel le couvercle est couplé au connecteur d'alimentation.

2. Appareil d'affichage de la revendication 1, ledit élément de verrouillage coulissant vers le couvercle pour entrer en contact avec le couvercle de façon à empêcher la rotation du couvercle lorsque le couvercle est couplé au connecteur d'alimentation.

3. Appareil d'affichage de la revendication 2, ledit élément de verrouillage comprenant :
une partie de fixation (510) fixée à ladite paroi du boîtier de circuit, et une partie de verrouillage (530) raccordée à la partie de fixation, et pouvant entrer en contact avec le couvercle pour empêcher la rotation du couvercle.

4. Appareil d'affichage de la revendication 3, ledit couvercle comprenant :
une partie de couvercle (610) formée de manière à correspondre au connecteur d'alimentation pour recevoir le connecteur d'alimentation dans un état dans lequel le couvercle est couplé au connecteur d'alimentation, et une saillie de retenue (620) faisant saillie à partir d'une surface externe de la partie de couvercle pour pouvoir entrer en contact avec la partie de verrouillage de façon à empêcher la rotation du couvercle.

5. Appareil d'affichage de la revendication 4, ladite partie de couvercle comprenant :
une première partie de couvercle (611) alignée avec ladite paroi dans un état dans lequel le couvercle est couplé au connecteur d'alimentation, et une seconde partie de couvercle (612) s'étendant à partir de la première partie de couvercle pour couvrir un périmètre du connecteur d'alimentation, et ladite saillie de retenue faisant saillie à partir d'une surface externe (612a) de la seconde partie de couvercle.

6. Appareil d'affichage de la revendication 5, comprenant en outre une vis (560) insérée dans ladite paroi à travers la partie de fixation pour permettre à l'élément de verrouillage d'être fixé à ladite paroi du boîtier de circuit, ledit élément de verrouillage pouvant coulisser par rapport à la vis pour verrouiller le couvercle.

7. Appareil d'affichage de la revendication 6, ledit élément de verrouillage comprenant en outre une partie inclinée (520) inclinée par rapport à la partie de fixation vers la partie de verrouillage dans une direction s'éloignant de ladite paroi.

8. Appareil d'affichage de la revendication 7, ledit couvercle étant tourné dans une première direction pour être verrouillé premièrement au connecteur d'alimentation lorsque le couvercle est couplé au connecteur d'alimentation, et ledit élément de verrouillage coulissant vers le couvercle pour entrer en contact avec le couvercle afin de verrouiller secondairement le couvercle de façon à empêcher le couvercle de tourner dans une seconde direction opposée à la première direction.

9. Appareil d'affichage de la revendication 8, ledit couvercle comprenant en outre une saillie de montage (630) faisant saillie à partir d'une surface interne (612b) de la seconde partie de couvercle de sorte que le couvercle soit premièrement verrouillé au connecteur d'alimentation.

10. Appareil d'affichage de la revendication 9, ledit connecteur d'alimentation comprenant :
une partie de raccordement (361), une paroi externe (362) couvrant un périmètre de la partie de raccordement, et un évidement de montage (363) formé sur la paroi externe de sorte que la saillie de montage puisse être montée dans un état dans lequel le couvercle est premièrement verrouillé au connecteur d'alimentation.

11. Appareil d'affichage de la revendication 1, comprenant en outre un conduit de câbles (700) pouvant être raccordé au connecteur d'alimentation pour fournir de l'énergie au module d'affichage à partir de l'extérieur,
ledit conduit de câbles comprenant :
une partie de raccordement (711) de conduit de câbles raccordée au connecteur d'alimentation, et
un couvercle (712) de conduit de câbles conçu pour couvrir un périmètre de la partie de raccordement de conduit de câbles, et dans un état dans lequel le couvercle est retiré du connecteur d'alimentation, ledit conduit de câbles étant couplé au connecteur d'alimentation et ledit élément de verrouillage entrant en contact avec le couvercle de conduit de câbles pour empêcher la rotation du couvercle de conduit de câbles.

12. Appareil d'affichage de la revendication 11, ledit élément de verrouillage comprenant :
une partie de fixation (510) fixée à ladite paroi, une partie inclinée (520) inclinée par rapport à la partie de fixation dans une direction s'éloignant de ladite paroi, et une partie de verrouillage (530) raccordée à la partie inclinée sur un côté éloigné de ladite paroi et pouvant entrer en contact avec le couvercle de conduit de câbles pour empêcher la rotation du couvercle de conduit de câbles.

13. Appareil d'affichage de la revendication 12, ledit couvercle de conduit de câbles comprenant une saillie de retenue (620) faisant saillie à partir d'une surface externe (612a) du couvercle de conduit de câbles pour pouvoir entrer en contact avec la partie de verrouillage afin d'empêcher la rotation du couvercle de conduit de câbles.

14. Appareil d'affichage de la revendication 13, ledit couvercle de conduit de câbles comprenant en outre une saillie de fixation (510) faisant saillie à partir d'une surface interne du couvercle de conduit de câbles de sorte que le couvercle de conduit de câbles soit premièrement verrouillé au connecteur d'alimentation.

15. Appareil d'affichage de la revendication 14, dans un état dans lequel le conduit de câbles et le connecteur d'alimentation sont raccordés l'un à l'autre, ledit couvercle de conduit de câbles étant tourné dans une première direction pour être verrouillé premièrement au connecteur d'alimentation, et ledit élément de verrouillage coulissant vers le couvercle de conduit de câbles pour verrouiller secondairement le couvercle de conduit de câbles de façon à empêcher le couvercle de conduit de câbles de tourner dans une seconde direction opposée à la première direction.
